# EUROPEAN PATENT APPLICATION

(11) **EP 4 310 898 A1**
(43) Date of publication of application: **24.01.2024**
(21) Application number: 23186594.0
(22) Date of filing: 20.07.2023
(51) Int. Cl.: H01L 21/762, H01L 29/06, H01L 21/84

(54) **BULK SEMICONDUCTOR SUBSTRATE WITH FULLY ISOLATED SINGLE-CRYSTALLINE SILICON ISLANDS AND THE METHOD FOR FORMING THE SAME**

(30) Priority: 21.07.2022 US 202263390997 P; 30.05.2023 US 202318203264
(71) Applicant: Invention And Collaboration Laboratory Pte. Ltd., Singapore 068914 (SG)
(72) Inventor: LU, Chao-Chun, 30078 Hsinchu (TW)
(74) Representative: Krauns, Christian

(57) **Abstract**

A semiconductor structure includes a bulk semiconductor substrate with an original semiconductor surface, a semiconductor island region, a shallow trench insulator (STI) region and a buried insulator layer. The semiconductor island region is formed based on the bulk semiconductor substrate. The STI region surrounds the semiconductor island region. The buried insulator layer is a localized insulator layer under the semiconductor island region, wherein a bottom surface of the semiconductor island region is fully isolated from the bulk semiconductor substrate by the buried insulator layer.

## Description

### BACKGROUND

### Technical Field

The disclosure relates in generally to a semiconductor substrate or wafer with fully isolated single-crystalline islands which are selectively formed, and in particular to single-crystalline islands fully isolated from a bulk semiconductor wafer without using an entire SOI wafer.

### Description of the Related Art

The traditional SOI (silicon-on-insulator) transistor generally made in an entire SOI wafer is much more expensive than that made in a bulk silicon wafer. As a result, one disadvantage of the SOI transistor technology is that the cost per transistor made in a SOI wafer is much higher than that made in a bulk silicon wafer.

For example, several novel methods are used to prepare a SOI wafer; for example, bonding together two wafers each of which has silicon oxide on the surface of a bulk-substrate wafer, respectively, and then by flipping one wafer on the other wafer and due to mutual oxide binding forces these two wafers are connected with these two layers of oxide to be sandwiched in between two oxide-covered bulk wafers; afterwards one wafer is ground to a specific thickness to result in a SOI wafer. Another method used to prepare a SOI wafer is implanting oxide atoms through the silicon wafer surface, which results in a thin silicon film over the implanted oxide layer which has been created on the original Silicon substrate.

Both methods are used to create an entire SOI wafer at much higher costs than that of a bulk silicon wafer, especially to the larger wafer diameter (e.g. 8" or 12"). Then the well-known silicon processing method can create the MOSFET (Metal-Oxide-Semiconductor Field-Effect-Transistor) in a SOI wafer.

Another disadvantage of the SOI transistor is that the cost for manufacturing the SOI transistor, therefore, can hardly meet the demand on cost reduction per scaled process node as Moore's Law dictates, so SOI technology did not become a mainstream or a commodity process technology that is dominated by the bulk-silicon-substrate technology.

Therefore, there is a need of providing an improved semiconductor structure and the method for fabricating the same to obviate the drawbacks encountered from the prior art.

### SUMMARY OF THE INVENTION

One embodiment of the present disclosure is to provide a semiconductor structure, wherein the semiconductor structure includes a bulk semiconductor substrate with an original semiconductor surface, a first semiconductor island region based on the bulk semiconductor substrate, a first shallow trench insulator (STI) region, a first buried insulator layer, a second semiconductor island region based on the bulk semiconductor substrate, a second STI region, and a second buried insulator layer. The first STI region surrounds sidewalls of the first semiconductor island region, and the second STI region surrounds sidewalls of the second semiconductor island region. The first buried insulator layer is formed and localized under the first semiconductor island region, and the second buried insulator layer is formed and localized under the second semiconductor island region. Wherein the first buried insulator layer is physically spaced apart from the second buried insulator layer.

In one aspect of the present disclosure, a bottom surface of the first semiconductor island region is fully isolated from a rest portion of the bulk semiconductor substrate by the first buried insulator layer, and a bottom surface of the second semiconductor island region is fully isolated from the rest portion of the bulk semiconductor substrate by the second buried insulator layer. Wherein the rest portion of the bulk semiconductor substrate does not include the first semiconductor island region and the second semiconductor island region.

In one aspect of the present disclosure, wherein a width, length or thickness of the first buried insulator layer is different from that of the second buried insulator layer.

In one aspect of the present disclosure, wherein a width, length or thickness of the first semiconductor island region is different from that of the second semiconductor island region.

In one aspect of the present disclosure, wherein the first buried insulator layer laterally extends from an inner sidewall of the first STI region to another inner sidewall of the first STI region.

In one aspect of the present disclosure, wherein the first buried insulator layer does not extend across all of the bulk semiconductor substrate, and the second buried insulator layer does not extend across all of the bulk semiconductor substrate.

Another embodiment of the present disclosure is to provide a semiconductor structure, wherein the semiconductor structure includes a bulk semiconductor wafer with an original semiconductor surface, a set of semiconductor island regions selectively formed based on the bulk semiconductor wafer, a set of shallow trench insulator (STI) regions corresponding to the set of semiconductor island regions respectively, and a set of buried insulator layers corresponding to the set of semiconductor island regions respectively. The set of semiconductor island regions are physically separate from each other, and the set of buried insulator layers are under the original semiconductor surface and physically separated from each other. Wherein sidewalls of one semiconductor island region is surrounded by one corresponding STI region, and a bottom surface of the one semiconductor island region is above one corresponding buried insulator layer. The bottom surface of the one semiconductor island is fully isolated from a rest portion of the bulk semiconductor wafer by the one corresponding buried insulator layer, wherein the rest portion of the bulk semiconductor wafer does not include the set of semiconductor island regions.

In one aspect of the present disclosure, the one corresponding buried insulator layer is surrounded by the one corresponding STI region.

In one aspect of the present disclosure, the one corresponding buried insulator layer laterally extends from an inner sidewall of the one corresponding STI region to another inner sidewall of the one corresponding STI region.

In one aspect of the present disclosure, a lateral length of the one semiconductor island region is not greater than a lateral length of the one corresponding buried insulator layer.

In one aspect of the present disclosure, the set of buried insulator layers do not extend all over the bulk semiconductor wafer.

Yet another embodiment of the present disclosure is to provide a semiconductor structure, wherein the semiconductor structure comprises a bulk semiconductor substrate with an original semiconductor surface, a semiconductor island region based on the bulk semiconductor substrate, a first STI region surrounding the semiconductor island region, a buried insulator layer localized formed under the first semiconductor island region, a semiconductor body region based on the bulk semiconductor substrate, and a second STI region surrounding the semiconductor body region. Wherein the semiconductor island region is physically spaced apart from the semiconductor body region. A bottom surface of the semiconductor island region is fully isolated from a rest portion of the bulk semiconductor substrate by the buried insulator layer, wherein the rest portion of the bulk semiconductor substrate does not include the semiconductor island region and the semiconductor body region.

In one aspect of the present disclosure, the semiconductor body region is electrically coupled to the rest portion of the semiconductor body region.

In one aspect of the present disclosure, a width, length or thickness of the buried insulator layer is adjustable.

Yet another aspect of the present disclosure is to provide a method to form a semiconductor structure, wherein the method includes steps as follows: Firstly, a bulk semiconductor substrate made of a semiconductor material is prepared, wherein the bulk semiconductor substrate includes an original semiconductor surface. Next, a semiconductor body region is formed in the bulk semiconductor substrate, wherein a STI region surrounds the semiconductor body region. Then, a set of trenches are formed in the semiconductor body region to reveal a first sidewall and a second sidewall of the semiconductor material. Subsequently a localized buried insulator layer is grown based on the first sidewall and the second sidewall to form a semiconductor island region. Wherein the semiconductor island region is surrounded by the STI region, a bottom surface of the semiconductor island region is fully isolated from a rest portion of the bulk semiconductor substrate by the localized buried insulator layer, and the rest portion of the bulk semiconductor substrate does not include the semiconductor island region.

In one aspect of the present disclosure, the step of forming the set of trenches includes steps as follows: Firstly, the semiconductor body region is etched to form a set of temporary trenches. Next, a spacer layer is formed to cover sidewalls of the set of temporary trenches. Subsequently, bottom surfaces of the set of temporary trenches are etched to form the set of trenches and reveal the first sidewall and the second sidewall of the semiconductor material.

In one aspect of the present disclosure, the step of forming the set of trenches includes steps as follows: Firstly, the STI region is etched to form a set of temporary trenches. Next, a spacer layer is formed to cover sidewalls of the set of temporary trenches. Subsequently, bottom surfaces of the set of temporary trenches are etched to form the set of trenches and reveal the first sidewall and the second sidewall of the semiconductor material.

In one aspect of the present disclosure, a thickness of the semiconductor island region is dependent on a vertical length of the spacer layer under the original semiconductor surface.

In one aspect of the present disclosure, the spacer layer includes an oxide layer and a nitride layer. In another aspect of the present disclosure, the spacer layer only includes a nitride layer covering the silicon region.

In one aspect of the present disclosure, the step of growing the localized buried insulator layer includes steps as follows: Firstly, a first sub-buried insulator layer is formed and extends from the first sidewall into the semiconductor body region, and a second sub-buried insulator layer is formed and extends from the second sidewall into the semiconductor body region; wherein the first sub-buried insulator layer merges with the second sub-buried insulator layer into the localized buried insulator layer.

In one aspect of the present disclosure, the first sub-buried insulator layer and the second sub-buried insulator layer include thermal oxide.

In one aspect of the present disclosure, a thickness of the localized buried insulator layer is dependent on a vertical length of the first sidewall or the second sidewall.

In accordance with the aforementioned embodiments of the present disclosure, a single-crystalline silicon Island on insulator (SC-SIOI) technology with a process is newly disclosed to create at least one semiconductor structure on a bulk semiconductor substrate, that includes a semiconductor island (e.g., a single-crystalline silicon fin) surrounded by insulator layers including a STI region and a localized buried insulator layer. Since the semiconductor structure based on the bulk semiconductor substrate has a manufacturing cost less than that of a tradition SOI wafer, thus it can substitute the tradition SOI wafer for allowing different kinds of device (e.g., a MOSFET) forming thereon.

### BRIEF DESCRIPTION OF THE DRAWINGS

The above objects and advantages of the present disclosure will become more readily apparent to those ordinarily skilled in the art after reviewing the following detailed description and accompanying drawings, in which:

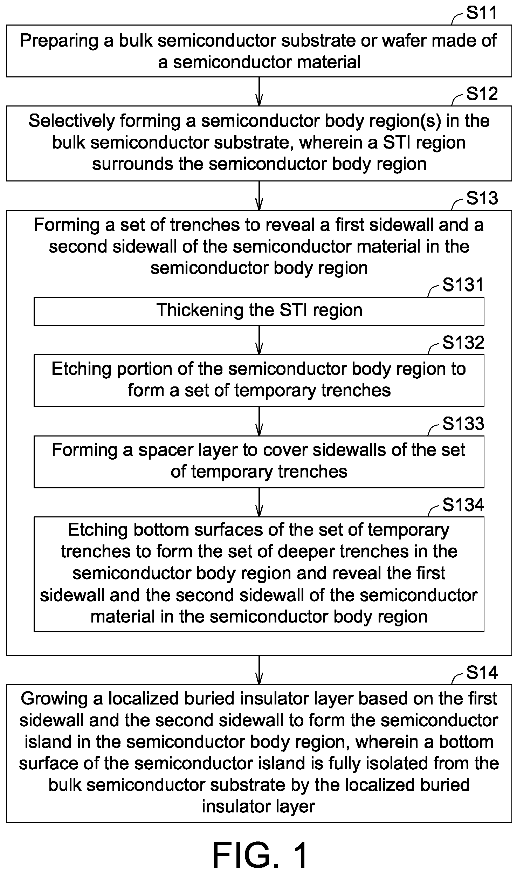

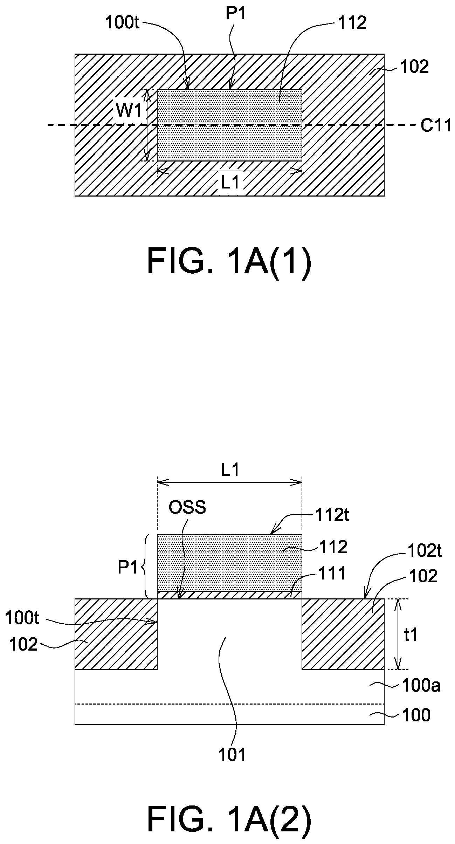

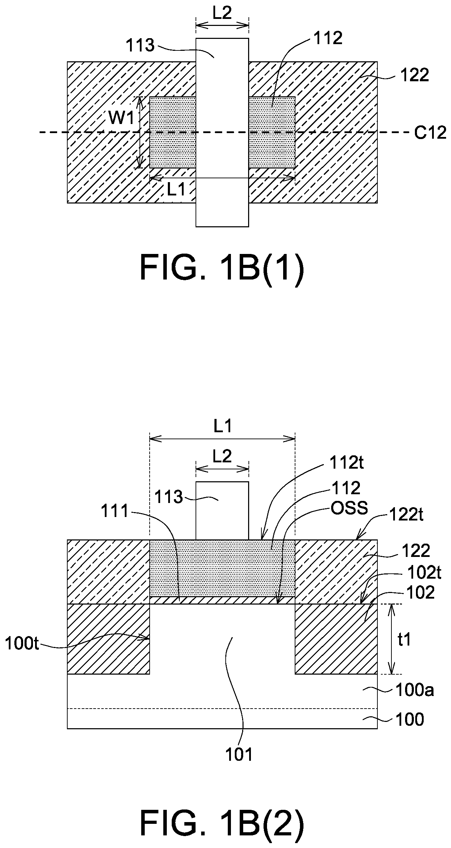

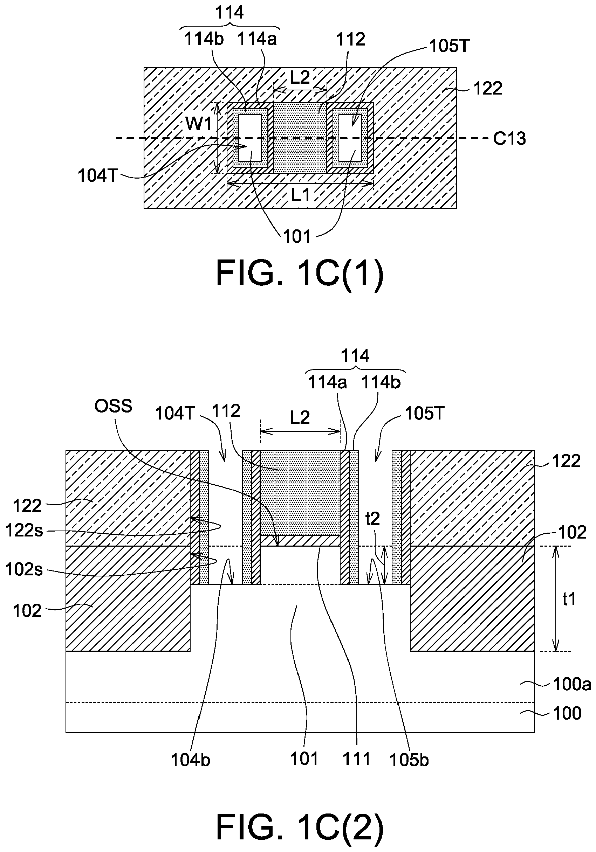

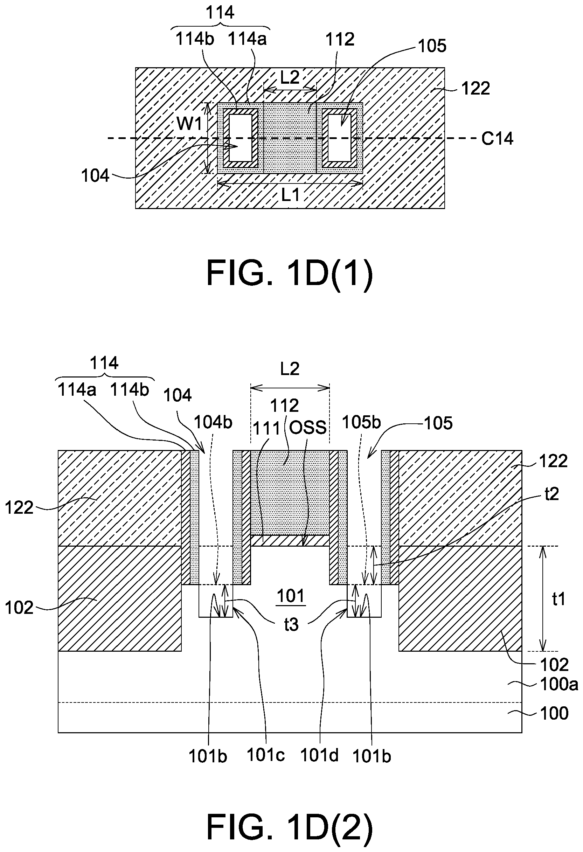

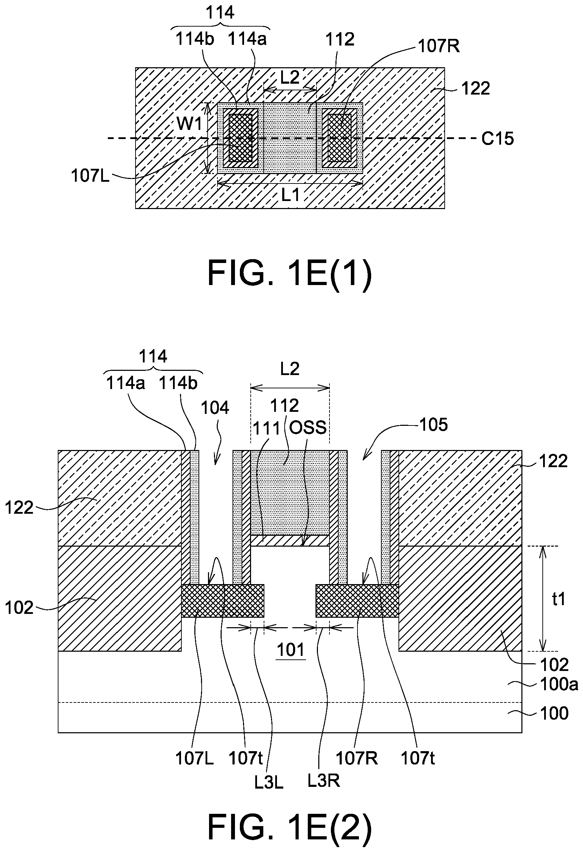

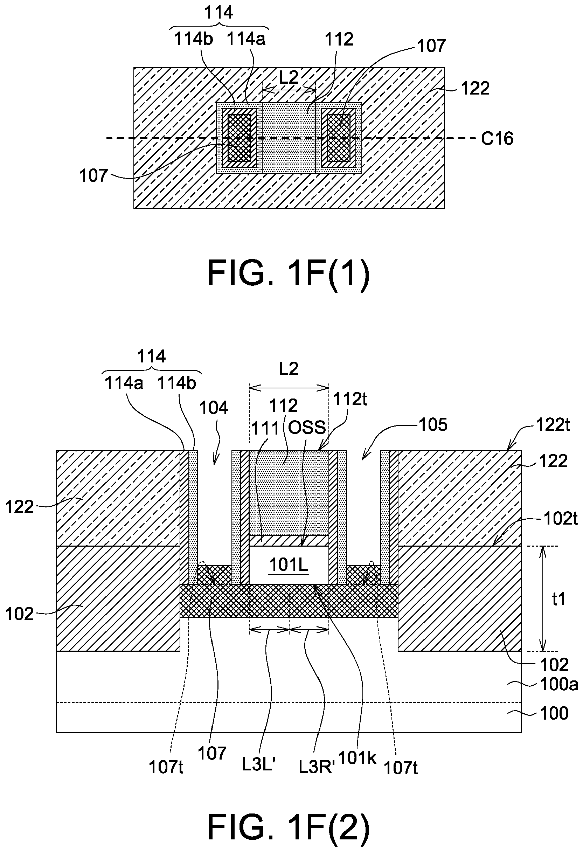

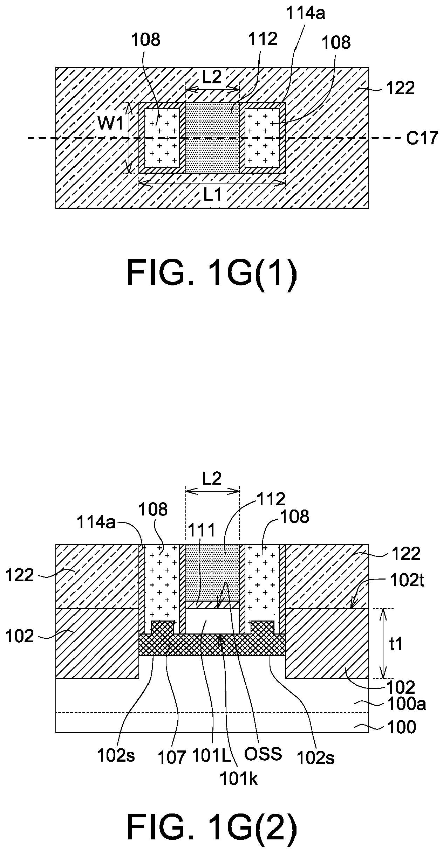

FIG. 1 is a flow chart illustrating the method for forming a semiconductor structure according to one embodiment of the present disclosure;
FIGS. 1A(1) to 1G(1) are top views of the processing structures for forming the semiconductor structure applying the method of FIG. 1;
FIGS. 1A(2) to 1G(2) are cross-sectional views of the processing structures corresponding to FIGS. 1A(1) to 1G(1);
FIG. 2 is a flow chart illustrating the method for forming a semiconductor structure according to another embodiment of the present disclosure;
FIGS. 2A(1) to 2D(1), and FIG. 2E(1) are top views of the processing structures for forming the semiconductor structure applying the method of FIG. 2.

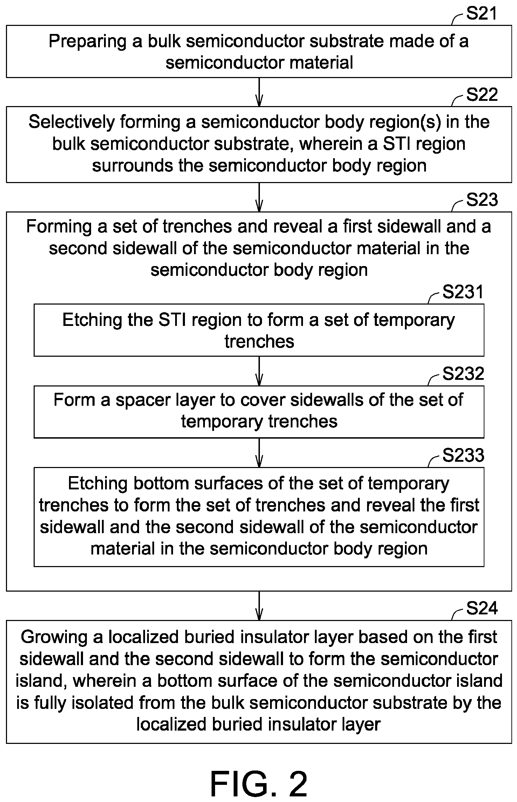

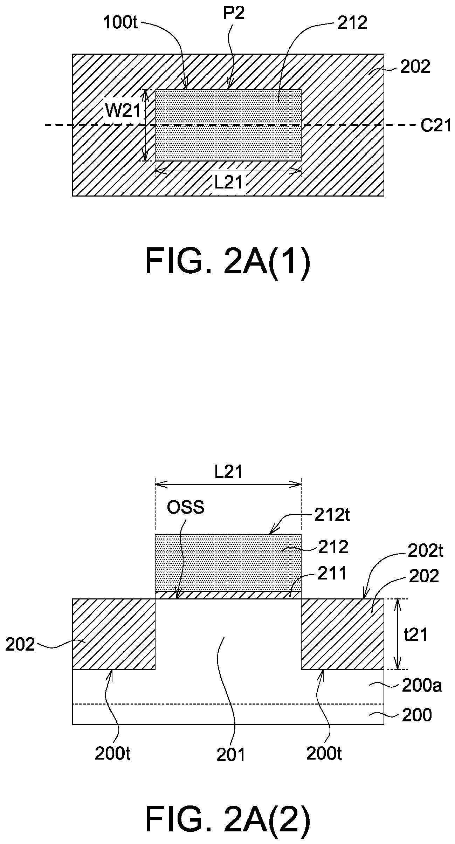

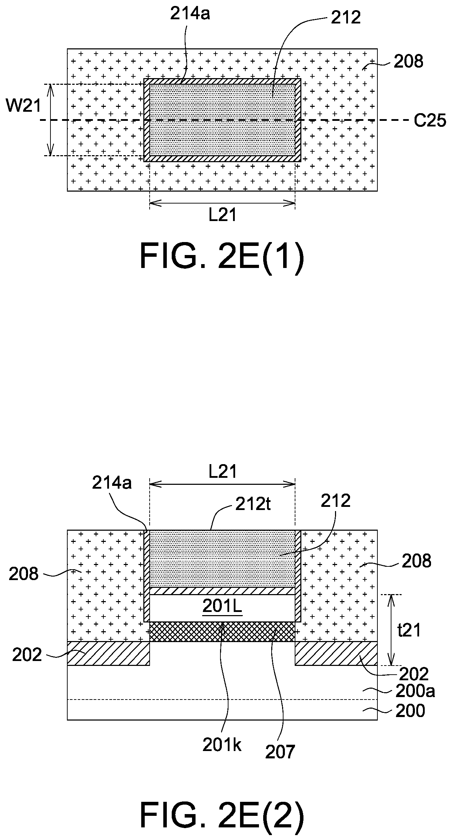

FIGS. 2A(2) to 2D(2), and FIG. 2E(2) are cross-sectional views of the processing structures corresponding to FIGS. 2A(1) to 2E(1);

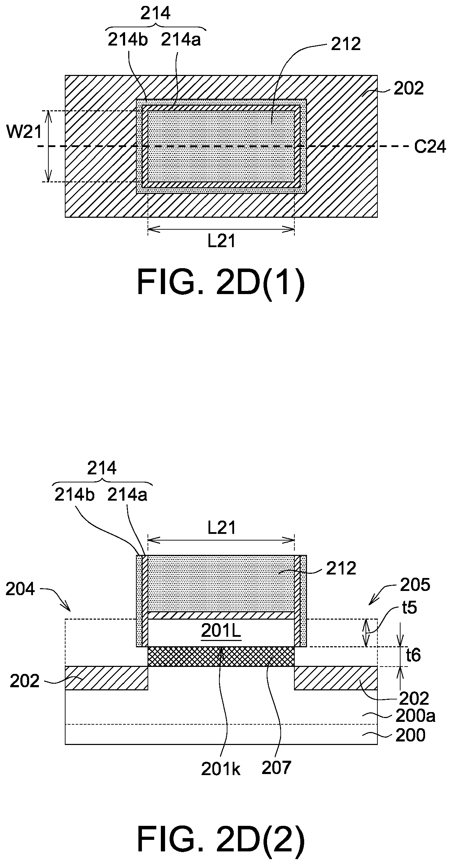

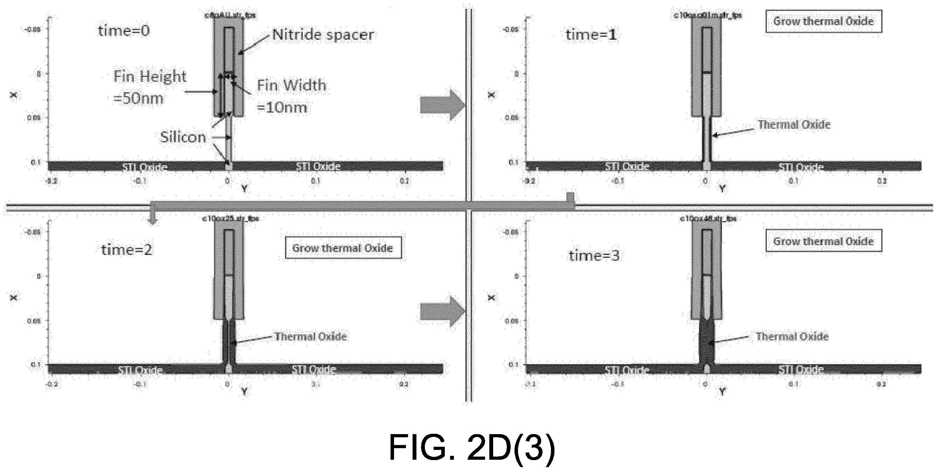

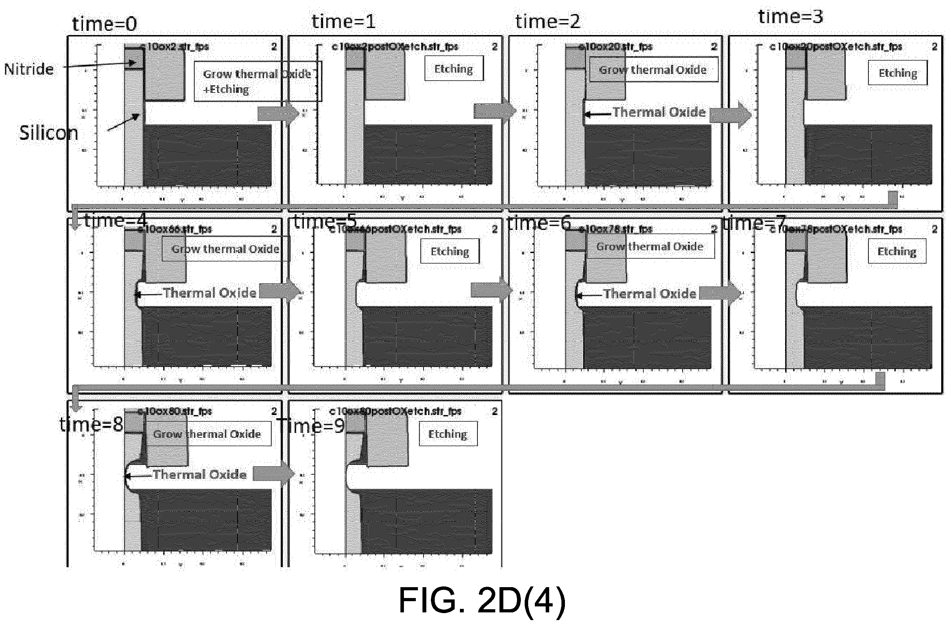

FIG. 2D(3) is the simulation result to form the localized buried insulator layer based on the fin structure;
FIG. 2D(4) is the simulation result to form the localized buried insulator layer by the repeated oxidation/etching process;

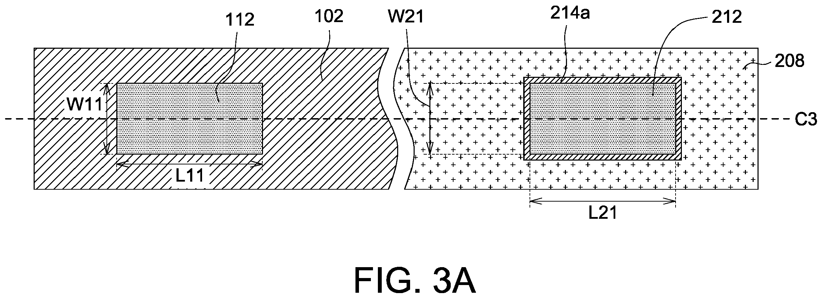

FIG. 3A is a top view illustrating a semiconductor structure according to yet another embodiment of the present disclosure; and

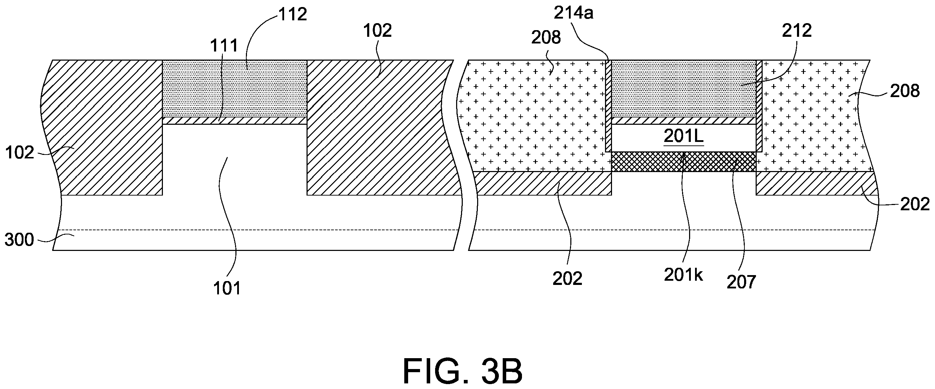

FIG. 3B is a cross-sectional view of the semiconductor structure taking along the cutting line C3 as depicted in FIG. 3A.

### DETAILED DESCRIPTION

The embodiments as illustrated below provide a bulk semiconductor substrate with fully isolated single-crystalline islands which are selectively formed in the bulk semiconductor substrate, wherein the bulk semiconductor substrate with fully isolated single-crystalline islands has a cost less than that of a conventional entire SOI wafer. The present disclosure will now be described more specifically with reference to the following embodiments illustrating the structure and arrangements thereof.

It is to be noted that the following descriptions of preferred embodiments of this disclosure are presented herein for purpose of illustration and description only. It is not intended to be exhaustive or to be limited to the precise form disclosed. Also, it is also important to point out that there may be other features, elements, steps and parameters for implementing the embodiments of the present disclosure which are not specifically illustrated. Thus, the specification and the drawings are to be regard as an illustrative sense rather than a restrictive sense. Various modifications and similar arrangements may be provided by the persons skilled in the art within the spirit and scope of the present disclosure. In addition, the illustrations may not be necessarily drawn to scale, and the identical elements of the embodiments are designated with the same reference numerals.

### Embodiment 1

FIG. 1 is a flow chart illustrating the step for forming a bulk semiconductor substrate or wafer 100 with fully isolated single-crystalline islands according to one embodiment of the present disclosure. FIGS. 1A(1) to 1G(1) are top views of the processing structures for forming bulk semiconductor substrate or wafer 100 with fully isolated single-crystalline islands. FIGS. 1A(2) to 1G(2) are cross-sectional views of the processing structures corresponding to FIGS. 1A(1) to 1G(1), respectively. The forming of the semiconductor structure 10 includes steps as follows:

| | |
|---|---|
| Step S11: | preparing a bulk semiconductor substrate or wafer 100 made of a semiconductor material (such as Silicon); |
| Step S12: | selectively forming a semiconductor body region(s) 101 in the bulk semiconductor substrate 100, wherein a STI region 102 surrounds the semiconductor body region 101; |
| Step S13: | forming a set of trenches 104 and 105 to reveal a first sidewall 101c and a second sidewall 101d of the semiconductor material in the semiconductor body region 101; |
| Step S14: | growing a localized buried insulator layer 107 based on the first sidewall 101c and the second sidewall 101d to form the semiconductor island 101L in the semiconductor body region 101, wherein a bottom surface 101k of the semiconductor island 101L is fully isolated from the bulk semiconductor substrate 100 by the localized buried insulator layer 107. |

The Step S13 includes the following:

| | |
|---|---|
| Sub-Step S131: | thickening the STI region 102; |
| Sub-Step S132: | etching portion of the semiconductor body region 101 to form a set of temporary trenches 104T and 105T; |
| Sub-Step S133: | forming a spacer layer 114 to cover sidewalls of the set of temporary trenches 104T and 105T; |
| Sub-Step S134: | etching bottom surfaces 104b and 105b of the set of temporary trenches 104T and 105T to form the set of deeper trenches 104 and 105 in the semiconductor body region 101 and reveal the first sidewall 101c and the second sidewall 101d of the semiconductor material in the semiconductor body region 101. |

FIG.1A(1) is a top view illustrating the structure after a semiconductor body region 101 is formed in a bulk semiconductor substrate 100 made of a semiconductor material according to one embodiment of the present disclosure. FIG. 1A(2) is a cross-sectional view taken along the cutting line C11 as depicted in FIG.1A(1).

Refer to step S11, a bulk semiconductor substrate 100 made of silicon is prepared. In some embodiment of the present disclosure, a typical silicon wafer (either p-type or n-type) is provided, and the entire silicon wafer can serve as the bulk semiconductor substrate 100. In the present embodiment, the bulk semiconductor substrate 100 is a p-type silicon wafer including a p-well 100a.

Refer to step S12: a semiconductor body region 101 is formed in the bulk semiconductor substrate 100. Of course, it is possible to form multiple semiconductor body regions depending on the requirement. In some embodiments of the present disclosure, the semiconductor body region 101 may be a doped region formed in the bulk semiconductor substrate 100 and surrounded by a STI region 102. In the present embodiment, the semiconductor body region 101 may be a doped rectangular active single-crystalline silicon region.

The forming of the semiconductor body region 101 includes steps as follows: Firstly, a pad-oxide layer 111 and a pad-nitride layer 112 are formed on an original semiconductor surface (also referring to as an original silicon surface (OSS)) of the bulk semiconductor substrate 100 in sequence. Next, the pad-oxide layer 111 and the pad-nitride layer 112 are patterned by a photolithography and etching process to form a rectangular pattern P1 (with a length L1 x width W1) covering on the bulk semiconductor substrate 100.

Another etching process, using the patterned pad-oxide layer 111 and the patterned pad-nitride layer 112 as a mask, is performed to remove the portion of the bulk semiconductor substrate 100 not covered by the rectangular pattern P1, so as to form a trench 100t in the bulk semiconductor substrate 100 and define a rectangular single-crystalline semiconductor region serving as the semiconductor body region 101. The trench 100t has a depth t1 measured from the original semiconductor surface (OSS) of the bulk semiconductor substrate 100. The rectangular semiconductor body region 101 covered by the rectangular pattern P1 has a size of length L1 x width W1.

A deposition process, such as a low pressure vapor deposition (LPVD) process, is performed to deposit silicon oxide to fill the trench 100t. Then the deposited silicon oxide is etched back to level up with the original semiconductor surface (OSS) of the bulk semiconductor substrate 100, as shown in FIG. 1A(2). The remained silicon oxide filled in the trench 100t and surrounding the semiconductor body region 101 can serve as the STI region 102.

Refer to step S13: a set of trenches 104 and 105 (in the semiconductor body region 101) is formed to reveal a first sidewall 101c and a second sidewall 101d of the semiconductor material in the bulk semiconductor substrate 100. In some embodiments of the present disclosure, forming the set of trenches 104 and 105 includes several sub-steps S131-S134 described as follows:

Refer to sub-steps S131: Firstly, the STI region 102 is thickened. That is, another silicon oxide is deposited over the STI region 102 to increase the thickness of the STI region. Therefore, the top surface 102t of the STI region 102 can be leveled up to form a top surface 122t substantially coplanar with the top surface 112t of the patterned pad-nitride layer 112. FIG. 1B(1) is a top view illustrating the structure after the top surface 102t of the STI region 102a is leveled up according to one embodiment of the present disclosure. FIG. 1B(2) is a cross-sectional view taken along the cutting line C12 as depicted in FIG. 1B(1). As shown in FIG. 1B(2), the deposited silicon oxide may serve as a STI region 122 staked on the top surface 102t of the STI region 102, and the top surface 122t of the STI region 122 can have a level substantially the same to the top surface 112t of the patterned pad-nitride layer 112.

Refer to sub-steps S132: portion of the semiconductor body region 101 is etched to form a set of temporary trenches, such as the temporary trenches 104T and 105T. In this step, a photolithography technique is applied to form a patterned resistant layer 113 on the top surface 112t of the patterned pad-nitride layer 112 (as shown in FIG. 1B(2)). Wherein, the rectangle resistant pattern (the patterned resistant layer 113) has a length L2 shorter than the length L1 of the semiconductor body region 101.

Then an etching process, using the patterned resistant layer 113 as a mask, is perform to remove portions of the patterned pad-oxide layer 111 and the patterned pad-nitride layer 112 to reveal the original semiconductor surface (OSS) of the semiconductor body region 101. Next, an anisotropic etching technique, such as a reactive ion etching (RIE) process, is applied to remove the silicon materials of the semiconductor body region 101 on both left-hand side and right-hand side of the patterned resistant layer 113, so as to create the temporary trenches 104T and 105T partially extending into the semiconductor body region 101 with a depth t2 smaller than the depth t1 both measured from the original semiconductor surface (OSS), as shown in FIG. 1C(2).

In the present embodiment, the inner sidewalls 102s and 122s of the STI regions 102 and 122 as well as the vertical edges of the patterned pad-oxide layer 111, the patterned pad-nitride layer 112 and the semiconductor material of the semiconductor body region 101 can be exposed from the temporary trenches 104T and 105T.

Refer to sub-step S133: a spacer layer 114 is formed to cover the sidewalls of the set of temporary trenches 104T and 105T. In some embodiment, the spacer layer 114 may be a single spacer including a thin nitride spacer, or may be a composite spacer including a thin oxide spacer 114a and a thin nitride spacer 114b on the exposed sidewalls of the set of temporary trenches 104T and 105T. FIG. 1C(1) is a top view illustrating the structure after the spacer layer 114 are formed in the temporary trenches 104T and 105Tt according to one embodiment of the present disclosure. FIG. 1C(2)is a cross-sectional view taken along the cutting line C13 as depicted in FIG. 1C(1).

Refer to sub-step S134: the bottom surfaces104b and 105b of the set of temporary trenches 104T and 105T are etched to form the set of deeper trenches 104 and 105 in the semiconductor body region 101 and reveal the first sidewall 101c and the second sidewall 101d of the semiconductor material in the semiconductor body region 101. For example, anisotropic etching technique, such as a RIE process, is applied to remove a portion of the silicon materials of the semiconductor body region 101 from the set of temporary trenches 104T and 105T to form the set of deeper trenches 104 and 105 with a deeper depth t3 (measured from the bottom surfaces 104b and 105b to the bottoms 101b of the semiconductor material exposed from the set of trenches 104 and 105). Wherein the sum of the depth t2 and the deeper depth t3 is smaller than or equal to the depth t1 (as shown in FIG. 1D(2)). FIG. 1D(1) is a top view illustrating the structure after the set of deeper trenches 104 and 105 are formed according to one embodiment of the present disclosure. FIG. 1D(2) is a cross-sectional view taken along the cutting line C14 as depicted in FIG. 1D(1)

Refer to step S14: a localized buried insulator layer (or underground insulating layer which is below OSS) 107 is grown based on the first sidewall 101c and the second sidewall 101d to form the semiconductor island 101L in the semiconductor body region 101, wherein a bottom surface 101k of the semiconductor island 101L is fully isolated from the bulk semiconductor substrate 100 by the localized buried insulator layer 107.

In some embodiments of the present disclosure, the localized buried insulator layer 107 can be formed by multiple steps. For example, in the present embodiment, a pre-thermal oxidation process is performed to thermally grow silicon dioxide based on the exposed silicon surfaces of the first sidewall 101c and the second sidewall 101d in the set of deeper trenches 104 and 105, so as to form oxide layers (such as, the oxide layers 107R and 107L) having a top surface 107t below the original semiconductor surface (OSS). FIG. 1E(1) is a top view illustrating the structure after the oxide layers 107R and 107L are formed according to one embodiment of the present disclosure. FIG. 1E(2) is a cross-sectional view taken along the cutting line C15 as depicted in FIG. 1E(1).

As shown in FIG. 1E(2), the oxide layer 107L has an extending length L3L laterally extending into the semiconductor body region 101 from one edge of the spacer 114; and the oxide layer 107R formed in the trenches 105 has an extending length L3R laterally extending into the semiconductor body region 101 from another edge of the spacer 114.

Next, a continue thermal oxidation process is performed to laterally extending both length L3L and L3R of the oxide layers 107R and 107L, until the oxide layers 107R and 107L touch each other (that is, the extended length L3L' + the extended length L3R' = the length L2), as shown in FIG. 1F(2). Some oxide may be grown above the top surface 107t of the oxide layers 107R and 107L. FIG. 1F(1) is a top view illustrating the structure after the localized buried insulator layer (BIL) 107 is formed according to one embodiment of the present disclosure. FIG. 1F(2) is a cross-sectional view taken along the cutting line C16 as depicted in FIG. 1F(1).

As a result, a semiconductor island 101L is formed, and the bottom surface 101k of the semiconductor island 101L is isolated from the bulk semiconductor substrate 100 by the localized buried insulator layer (BIL) 107. The semiconductor island 101L is a single crystalline island, such as a silicon island, for further manufacturing transistor(s) therein.

Then the silicon nitride film 114b is removed. Afterward, form the high density deposited oxide layers 108 (such as, silicon-on-diamond (SOD)) filling in the set of trenches 104 and 105 and to create a flat surface either leveled up with the top surface of the patterned pad-nitride layer 112 or the top surface of the patterned pad-oxide layer 111 (by assuming that the pad-nitride layer 112 was already stripped). FIG. 1G(1) is a top view illustrating the structure after the high density deposited oxide layers 108 are formed according to one embodiment of the present disclosure. FIG. 1G(2) is a cross-sectional view taken along the cutting line C17 as depicted in FIG. 1G(1).

As a result, the bulk semiconductor substrate or wafer 100 having the single-crystalline silicon Island on insulator (SC-SIOI) region is formed. There can be many SC-SIOI regions which are enclosed by oxide isolation layers starting from a bulk semiconductor wafer without using an entire SOI wafer that is more expensive. The bottom of the SC-SIOI region is isolated from the bulk semiconductor substrate by the localized buried insulator layer 107, and the sidewalls of the SC-SIOI region is surrounded by the dielectric layers, such as STI regions 102 and 122. The SC-SIOI regions of the present invention could be ready for forming different kinds of transistors with various gate structures such as planar-gate, FinFET, Tri-Gate, gate-all-around (GAA) or gate around structure, sheet-channel or tube-channel based on subsequent formation processes.

### Embodiment 2

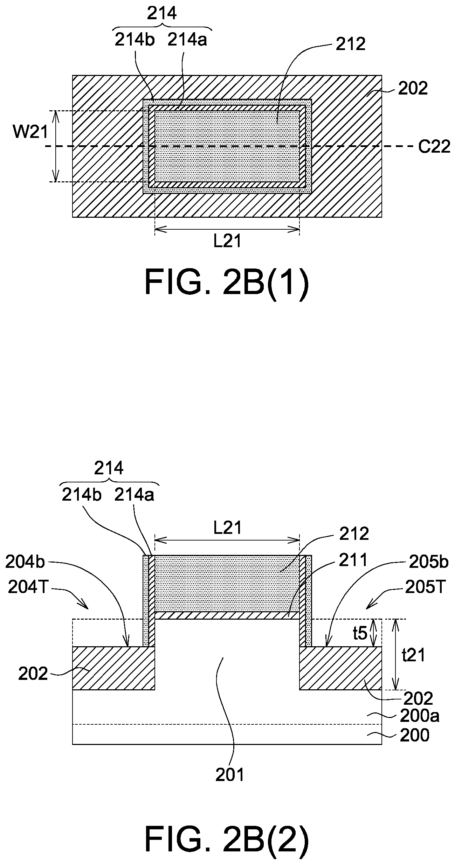

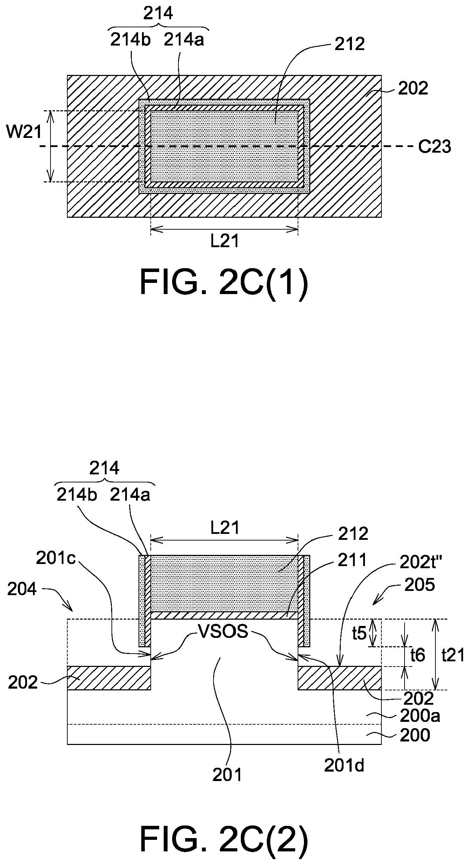

FIG. 2 is a flow chart illustrating the step for forming a semiconductor substrate or wafer 200 with single-crystalline silicon Island(s) according to another embodiment of the present disclosure. FIGS. 2A(1) to 2E(1) are top views of the processing structures for forming the semiconductor substrate or wafer 200 with single-crystalline silicon Island(s). FIGS. 2A(2) to 2E(2) are cross-sectional views of the processing structures corresponding to FIGS. 2A(1) to 2E(1), respectively. The forming of the semiconductor structure 20 includes steps as follows:

| | |
|---|---|
| Step S21: | preparing a bulk semiconductor substrate 200 made of a semiconductor material; |
| Step S22: | selectively forming a semiconductor body region(s) 201 in the bulk semiconductor substrate 200, wherein a STI region 202 surrounds the semiconductor body region 201; |
| Step S23: | forming a set of trenches and reveal a first sidewall 201c and a second sidewall 201d of the semiconductor material in the semiconductor body region 201; |
| Step S24: | growing a localized buried insulator layer 207 based on the first sidewall 201c and the second sidewall 201d to form the semiconductor island 201L, wherein a bottom surface 201k of the semiconductor island 201L is fully isolated from the bulk semiconductor substrate 200 by the localized buried insulator layer 207. |

The Step S23 includes the following:

| | |
|---|---|
| Sub-Step S231: | etching the STI region 202 to form a set of temporary trenches 204T and 205T; |
| Sub-Step S232: | form a spacer layer 214 to cover sidewalls 204s and 205s of |
| | the set of temporary trenches 204T and 205T; |
| Sub-Step S233: | etching bottom surfaces 204b and 205b of the set of temporary trenches 204T and 205T to form the set of trenches 204 and 205 and reveal the first sidewall 201c and the second sidewall 201d of the semiconductor material in the semiconductor body region 201. |

FIG.2A(1) is a top view illustrating the structure after a semiconductor body region 201 is formed in a bulk semiconductor substrate 200 made of a semiconductor material according to one embodiment of the present disclosure. FIG. 2A(2) is a cross-sectional view taken along the cutting line C21 as depicted in FIG.2A(1).

Refer to step S21: a bulk semiconductor substrate or wafer 200 made of is prepared. In some embodiment of the present disclosure, a typical silicon wafer (either p-type or n-type) is provided, and the entire silicon wafer can serve as the bulk semiconductor substrate 200. In the present embodiment, the bulk semiconductor substrate 200 is a p-type silicon wafer including a p-well 200a.

Refer to Step S22: a semiconductor body region 201 is formed in the bulk semiconductor substrate 200. In some embodiments of the present disclosure, the semiconductor body region 201 may be a doped region formed in the bulk semiconductor substrate 200 and surrounded by a STI region 202. In the present embodiment, the semiconductor body region 201 may be a doped rectangular active single-crystalline silicon region.

The forming of the semiconductor body region 201 includes steps as follows: Firstly, a pad-oxide layer 211 and a pad-nitride layer 212 are formed on an original semiconductor surface (OSS) of the bulk semiconductor substrate 200 in sequence. Next, the pad-oxide layer 211 and the pad-nitride layer 212 are patterned by a photolithography and etching process to form a rectangular pattern P2 (with a length L21 x width W21) covering the bulk semiconductor substrate 200.

Another etching process, using the patterned pad-oxide layer 211 and the patterned pad-nitride layer 212 as a mask, is performed to remove the portion of the bulk semiconductor substrate 200 not covered by the rectangular pattern P2, so as to form a trench 200t in the bulk semiconductor substrate 200 and define a rectangular single-crystalline silicon region serving as the semiconductor body region 201. The trench 200t has a depth t1 measured downwards from the original semiconductor surface (OSS) of the bulk semiconductor substrate 200. The rectangular semiconductor body region 201 covered by the rectangular pattern P2 has a size of length L21 x width W21.

A deposition process, such as a LPVD process, is performed to deposit silicon oxide to fill in the trench 200t. Then the deposit silicon oxide is etched back to level up with the original semiconductor surface (OSS), as shown in FIG. 2A(2). The remained silicon oxide filled in the trench 200t and surrounding the semiconductor body region 201 can serve as the STI region 202.

Refer to step S23: forming a set of trenches 204 and 205 (in the semiconductor body region 201) and reveal a first sidewall 201c and a second sidewall 201d of the semiconductor material. In some embodiments of the present disclosure, forming the set of trenches 204 and 205 includes several sub-steps S231-S233 described as follows:

Refer to sub-step S231: the STI region 202 is etched down to form a set of temporary trenches 204T and 205T. For example, a RIE process is applied to remove a portion of the STI region 202 and to expose a portion vertical sidewalls of the semiconductor body region 201. Wherein the STI region 202 is etched with a depth t5 measured from the original semiconductor surface (OSS).

Refer to sub-step S232: a spacer layer 214 is formed to cover the sidewalls of the set of temporary trenches 204T and 205T. Thus, the edge of the pad-oxide layer 211, the edge of the pad-nitride layer 212 as well as the exposed portion of the vertical sidewalls of the semiconductor body region 201 are covered by the spacer layer 214. FIG.2B(1) is a top view illustrating the structure after the spacer layer 214 is formed on the sidewalls of the set of temporary trenches 204T and 205T according to one embodiment of the present disclosure. FIG. 2B(2) is a cross-sectional view taken along the cutting line C22 as depicted in FIG.2B(1). In some embodiment, the spacer layer 214 may be a single spacer including a thin nitride spacer, or may be a composite spacer including a silicon oxide film 214a and a silicon nitride film 214b.

Refer to sub-step S233: the bottom surfaces 204b and 205b of the set of temporary trenches 204T and 205T are etched to form the set of trenches 204 and 205 in the semiconductor body region 201 and reveal the first sidewall 201c and the second sidewall 201d of the semiconductor material. FIG. 2C(1) is a top view illustrating the structure after the set of trenches 204 and 205 are formed according to one embodiment of the present disclosure. FIG. 2C(2) is a cross-sectional view taken along the cutting line C23 as depicted in FIG.2C(1).

For example, a RIE process could be applied to remove a portion of the STI regions 202 from the bottom surfaces 204b and 205b of the set of temporary trenches 204T and 205T with a depth t6 (measured from the bottom surfaces 204b and 205b to the top surface 202t" of the etched STI regions 202) to form the set of deeper trenches 204 and 205. Wherein the sum of the depth t5 and the depth t6 is smaller than or equal to the depth t21.

As shown in FIG. 2C(2), the portion of the vertical sidewall of the semiconductor body region 201 that is blow the spacer layer 214 but above the top surface 202t" of the etched STI regions 202, with the depth t6 and exposed from the trench 204 is referred to as the first sidewall 201c of the semiconductor material; and the other portion of that exposed from the trench 205 is referred to as the second sidewall 201d of the semiconductor material.

In the present embodiment, the first sidewall 201c and the second sidewall 201d of the semiconductor material are well exposed as the seed of the subsequent oxidation process and also called as vertical silicon oxidation seed (VSOS). The rest portion of the bulk semiconductor substrate 200 covered by either the spacer layer 214 or the etched STI regions 202 are protected form be affected by the subsequent oxidation process.

Refer to step S24: a localized buried insulator layer or underground insulating layer 207 is grown based on the first sidewall 201c and the second sidewall 201d to form the semiconductor island 201L, wherein a bottom surface 201k of the semiconductor island 201L is fully isolated from the bulk semiconductor substrate 200 by the localized buried insulator layer 207.

For example, an oxidation process is conducted thermally with special designs over the VSOS regions (i.e., the first sidewall 201c and the second sidewall 201d of the semiconductor material). Thermally grown silicon dioxide layers are formed from the exposed VSOS of the single crystalline silicon regions (i.e., the first sidewall 201c and the second sidewall 201d of the semiconductor body region 201) until the forefront edges of the silicon dioxide layers are touched.

Therefore, a semiconductor island (or semiconductor island region) 201L is formed, and the bottom surface 201k of the semiconductor island 201L is isolated from the bulk semiconductor substrate 200 by the localized buried insulator layer or the underground insulating layer 207. Thus, a desired silicon island on insulator (SIOI) structure is made without a need of using expensive, entire SOI wafers as most popularly used today. This SIOI structure can be well used as a "substrate" to house silicon transistors or other devices. In the present embodiment, the localized buried insulator layer 207 has a length substantially equal to the length L21 of the semiconductor body region 201. FIG. 2D(1) is a top view illustrating the structure after the localized buried insulator layer is formed according to one embodiment of the present disclosure. FIG. 2D(2) is a cross-sectional view taken along the cutting line C24 as depicted in FIG.2D(1).

Moreover, the thickness of the semiconductor island 201L could be dependent on t5, and the thickness of the localized buried insulator layer 207 could be dependent on t6. With suitable adjustment or control of W21, L21, t5 and t6 shown in FIG. 2D(1) and FIG. 2D(2), different semiconductor island region in the bulk semiconductor substrate 200 may have different length, width, and thickness, and different localized buried insulator layer in the bulk semiconductor substrate 200 may have different length, width, and thickness.

FIG. 2D(3) shows the simulation result, based on TCAD simulation by Sentaurus, to form the localized buried insulator layer (majorly made of SiO₂) based on the semiconductor body region 201 which is a fin structure, the fin height is 50nm, and the fin width is 10nm. At the thermal oxidation temperature is 700°C, it is found that the bottom of the fin structure is fully covered by the thermally formed oxide layer, or the localized buried insulator layer.

Alternatively, another way to form the localized buried insulator layer could be described as follows. Based on those vertical silicon sidewalls VSOS shown in FIG. 2C(2), a repeated oxidation/etching process is conducted with special designs over those vertical silicon sidewalls VSOS to remove most of the silicon material between those vertical silicon sidewalls VSOS. As shown in FIG. 2D(4) which simulates, based on TCAD simulation by Sentaurus, the repeated oxidation/etching process against the structure corresponding to one side of the VSOS shown in FIG. 2C(2), at time=0, a thin thermal oxide is grown on the vertical silicon sidewall of the VSOS at 800°C, and at time=1, the previously grown thermal oxide is etched to reveal the silicon surface. Again, at time=2, a thin thermal oxide is then grown on the revealed silicon sidewall at 800°C, and at time=3, the previously grown thermal oxide at time =2 is etched to reveal the silicon surface again. Such oxidation/etching process is repeated (at time=4-time=9) until most of the silicon material between those vertical silicon sidewalls VSOS is removed and only residual silicon is left as shown in FIG. 2D(4). Therefore, a horizontal cavity or a surrounding trench is formed and surrounds the residual silicon. Thereafter, a thermal oxidation is performed such that all residual silicon is turned into thermal oxide (hereinafter, the neck thermal oxide). Then, the CVD (Chemical Vapor Deposition) technique is used to deposit and etch back oxide film to completely fill the horizontal cavity or the surrounding trench. Therefore, the localized buried insulator layer is finalized.

Then the silicon nitride film 214b is removed. Afterward, form the high density deposited oxide layers 208 (such as, silicon-on-diamond (SOD)) filling in the set of deeper trenches 204 and 205 and to create a flat surface either leveled up with the top surface of the patterned pad-nitride layer 212 or the top surface of the patterned pad-oxide layer 211 (by assuming that the pad-nitride layer 212 was already stripped). FIG. 2E(1) is a top view illustrating the structure after the high density deposited oxide layers 208 are formed according to one embodiment of the present disclosure. FIG. 2E(2) is a cross-sectional view taken along the cutting line C25 as depicted in FIG.2E(1).

As a result, the bulk semiconductor substrate or wafer 200 having the single-crystalline silicon Island(s) on insulator (SC-SIOI) region is formed. There can be many SC-SIOI regions which are enclosed by oxide isolation layers starting from a bulk semiconductor wafer without using an entire SOI wafer that is more expensive. The SC-SIOI regions of the present invention could be ready for forming different kinds of transistors with various gate structures such as planar-gate, FinFET, Tri-Gate, gate-all-around (GAA) or gate around structure, sheet-channel or tube-channel based on subsequent formation processes.

Therefore, according to the present invention, a bulk semiconductor substrate or wafer can include many SC-SIOI regions which are selectively formed, each SC-SIOI region includes a single-crystalline silicon island which is insulated from the bulk semiconductor substrate by oxide isolation layers, for example, the bottom of the single-crystalline silicon island is insulated by the buried insulator layer 207, and sidewalls of the single-crystalline silicon island is insulated by STI region or other dielectric layers. Furthermore, the bulk semiconductor substrate or wafer still has other semiconductor body regions which are still electrically coupled to the bulk semiconductor substrate. FIG.3A is a top view illustrating the bulk semiconductor substrate with many SC-SIOI regions and semiconductor body regions according to embodiment of the present disclosure. FIG. 3B is a cross-sectional view taken along the cutting line C3 as depicted in FIG.3A.

In FIG. 3A and 3B, the bulk semiconductor substrate 300 at least includes a first semiconductor body region 101, a first STI region 102 surrounding the first semiconductor body region 101, a second semiconductor island 201L, a second STI region 202 and a second buried insulator layer 207. The second semiconductor island 201L is isolated from a rest portion of the bulk semiconductor substrate 300 (not including the first semiconductor body region 101 and the second semiconductor island 201L). However, the first semiconductor body region 101 is electrically coupled to the rest portion of the bulk semiconductor substrate 300. Both of the first semiconductor body region 101 and the second semiconductor island 201L could be ready for forming different kinds of transistors. Thus, the bulk semiconductor substrate 300 of the present invention can substitute the tradition SOI wafer for different kinds of device (e.g., a MOSFET) forming thereon.

While the disclosure has been described by way of example and in terms of the exemplary embodiment(s), it is to be understood that the disclosure is not limited thereto. On the contrary, it is intended to cover various modifications and similar arrangements and procedures, and the scope of the appended claims therefore should be accorded the broadest interpretation so as to encompass all such modifications and similar arrangements and procedures.

## Claims

1. A semiconductor structure, comprising:
a bulk semiconductor substrate with an original semiconductor surface;
a first semiconductor island region formed based on the bulk semiconductor substrate;
a first STI region surrounding sidewalls of the first semiconductor island region;
a first buried insulator layer which is formed and localized under the first semiconductor island region;
a second semiconductor island region formed based on the bulk semiconductor substrate;
a second STI region surrounding sidewalls of the second semiconductor island region; and
a second buried insulator layer which is formed and localized under the second semiconductor island region;
wherein the first buried insulator layer is physically spaced apart from the second buried insulator layer.

2. The semiconductor structure according to claim 1, wherein:
a bottom surface of the first semiconductor island region is fully isolated from a rest portion of the bulk semiconductor substrate by the first buried insulator layer; and
a bottom surface of the second semiconductor island region is fully isolated from the rest portion of the bulk semiconductor substrate by the second buried insulator layer;
wherein the rest portion of the bulk semiconductor substrate does not include the first semiconductor island region and the second semiconductor island region.

3. The semiconductor structure according to claim 1 or 2, wherein a width, length or thickness of the first buried insulator layer is different from that of the second buried insulator layer.

4. The semiconductor structure according to anyone of the claims 1 to 3, wherein a width, length or thickness of the first semiconductor island region is different from that of the second semiconductor island region.

5. The semiconductor structure according to anyone of the claims 1 to 4, wherein the first buried insulator layer laterally extends from an inner sidewall of the first STI region to another inner sidewall of the first STI region.

6. The semiconductor structure according to anyone of the claims 1 to 4, wherein the first buried insulator layer does not extend across all of the bulk semiconductor substrate, and the second buried insulator layer does not extend across all of the bulk semiconductor substrate.

7. A semiconductor structure, comprising:
a bulk semiconductor wafer with an original semiconductor surface;
a set of semiconductor island regions selectively formed based on the bulk semiconductor wafer, wherein the set of semiconductor island regions are physically separate from each other;
a set of shallow trench insulator (STI) regions corresponding to the set of semiconductor island regions respectively, wherein sidewalls of one semiconductor island region is surrounded by one corresponding STI region; and
a set of buried insulator layers corresponding to the set of semiconductor island regions respectively, wherein the set of buried insulator layer are under the original semiconductor surface and physically separate from each other, and a bottom surface of the one semiconductor island region is above one corresponding buried insulator layer;
wherein the bottom surface of the one semiconductor island is fully isolated from a rest portion of the bulk semiconductor wafer by the one corresponding buried insulator layer, wherein the rest portion of the bulk semiconductor wafer does not include the set of semiconductor island regions.

8. The semiconductor structure according to claim 7, wherein the one corresponding buried insulator layer is surrounded by the one corresponding STI region.

9. The semiconductor structure according to claim 7 or 8, wherein the one corresponding buried insulator layer laterally extends from an inner sidewall of the one corresponding STI region to another inner sidewall of the one corresponding STI region.

10. The semiconductor structure according to anyone of the claims 7 to 9, wherein a lateral length of the one semiconductor island region is not greater than a lateral length of the one corresponding buried insulator layer.

11. The semiconductor structure according to anyone of the claims 7 to 10, wherein the set of buried insulator layers do not extend all over the bulk semiconductor wafer.

12. A semiconductor structure, comprising:
a bulk semiconductor substrate with an original semiconductor surface;
a semiconductor island region based on the bulk semiconductor substrate;
a first STI region surrounding the semiconductor island region;
a buried insulator layer localized formed under the first semiconductor island region;
a semiconductor body region based on the bulk semiconductor substrate, wherein the semiconductor island region is physically spaced apart from the semiconductor body region; and
a second STI region surrounding the semiconductor body region;
wherein a bottom surface of the semiconductor island region is fully isolated from a rest portion of the bulk semiconductor substrate by the buried insulator layer, wherein the rest portion of the bulk semiconductor substrate does not include the semiconductor island region and the semiconductor body region.

13. The semiconductor structure according to claim 12, wherein the semiconductor body region is electrically coupled to the rest portion of the semiconductor body region.

14. A method to form a semiconductor structure, comprising:
preparing a bulk semiconductor substrate made of a semiconductor material, wherein the bulk semiconductor substrate includes an original semiconductor surface;
forming a semiconductor body region in the bulk semiconductor substrate, wherein a STI region surrounds the semiconductor body region;
forming a set of trenches in the semiconductor body region to reveal a first sidewall and a second sidewall of the semiconductor material; and
growing a localized buried insulator layer based on the first sidewall and the second sidewall to form a semiconductor island region;
wherein the semiconductor island region is surrounded by the STI region, and a bottom surface of the semiconductor island region is fully isolated from a rest portion of the bulk semiconductor substrate by the localized buried insulator layer wherein the rest portion of the bulk semiconductor substrate does not include the semiconductor island region.

15. The method according to claim 14, wherein the step of forming the set of trenches comprises:
etching the STI region to form a set of temporary trenches;
forming a spacer layer to cover sidewalls of the set of temporary trenches; and
etching bottom surfaces of the set of temporary trenches to form the set of trenches in the semiconductor body region and reveal the first sidewall and the second sidewall of the semiconductor material.

16. The method according to claim 14 or 15, wherein a thickness of the semiconductor island region is dependent on a vertical length of the spacer layer under the original semiconductor surface, and the spacer layer includes a nitride layer

17. The method according to anyone of the claims 14 to 16, wherein the step of growing the localized buried insulator layer comprises:
forming a first sub-buried insulator layer extending from the first sidewall into the semiconductor body region; and
forming a second sub-buried insulator layer extending from the second sidewall into the semiconductor body region;
wherein the first sub-buried insulator layer merges with the second sub-buried insulator layer into the localized buried insulator layer.

18. The method according to anyone of the claims 14 to 17, wherein the step of forming the set of trenches comprises:
etching the semiconductor body region to form a set of temporary trenches;
forming a spacer layer to cover sidewalls of the set of temporary trenches; and
etching bottom surfaces of the set of temporary trenches to form the set of trenches in the semiconductor body region and reveal the first sidewall and the second sidewall of the semiconductor material.
